# EUROPEAN PATENT SPECIFICATION

(11) **EP 3 889 624 B1**
(45) Date of publication and mention of the grant of the patent: **02.07.2025**
(21) Application number: 21166422.2
(22) Date of filing: 31.03.2021
(51) Int. Cl.: G01R 31/34, H02J 3/00

(54) **PROTECTION AGAINST EXCITATION AT STANDSTILL OF THE GENERATOR**
SCHUTZ GEGEN ERREGUNG BEI STILLSTAND VOM GENERATOR
PROTECTION CONTRE L'EXCITATION AU NIVEAU D'UN GÉNÉRATEUR D'ARRÊT

(30) Priority: 01.04.2020 CN 202010249293
(43) Date of publication of application: 06.10.2021
(73) Proprietor: Siemens Aktiengesellschaft, 80333 München (DE)
(72) Inventor: MA, Yan, Nanjing, 210000 (CN); HU, Chuan Li, Nanjing, 211100 (CN); WANG, Ya Li, Nanjing, 211100 (CN); CUI, Feng Xian, Nanjing, 211100 (CN); WANG, Fei, Nanjing, Jiangsu Province, 211100 (CN); BÖHME, Klaus, 12305 Berlin (DE); SCHNEIDER, Sebastian, 90522 Oberasbach (DE)
(74) Representative: HKW Intellectual Property PartG mbB

(56) References cited:
- DE-A1- 3 011 857
- US-A- 4 814 700

## Description

### Technical Field

The present invention relates to the field of generators, in particular to a method, an apparatus, and a power supply system for determining a state of a generator in a power supply system.

### Background Art

A generator is an important device in a power system, and its safe running plays a decisive role in guaranteeing the stable running and power quality of the power system. An excitation system for a generator may provide an adjustable DC current to an excitation winding of a generator. The excitation winding of the generator cuts the magnetic lines of force while the generator rotates, allowing the generator to generate an alternating current and then transmit power to a transmission grid. DE 30 11 857 A1 discloses a battery charging system, in particular for motor vehicles. US 4,814,700 A discloses a field current measurement device.

### Summary of the Invention

Against the above-described background, the present invention proposes a method for determining a state of a generator in a power supply system as defined in the appended claims.

According to the present invention, a state of a generator is monitored to determine, in a timely manner, whether an excitation system is switched on when the generator is in a standstill state, and a prompt message is sent, so that an operator can perform follow-up processing operations according to the prompt message; this allows a reduction of damage to the generator.

According to the method as described above, optionally, said monitoring whether the generator is in a standstill state comprises:
periodically judging whether the generator meets the following preset condition: the frequency of the generator is smaller than or equal to a first preset threshold;
and, if the judgment result is yes, determining that the generator is in the standstill state.

According to the method as described above, optionally, the preset condition further comprises: an output voltage of the generator is smaller than or equal to a second preset threshold.

The method as described above, optionally, after monitoring that the excitation system is switched on, further comprises:
triggering a switch-off operation of the excitation system.

The method as described above, optionally, further comprises:
after monitoring that the generator is in a standstill state, activating a prompt function, the prompt function being used for monitoring whether the excitation system is switched on and, after monitoring that it is switched on, sending the prompt message.

The method as described above, optionally, after activating the prompt function, further comprises: if it is monitored that the generator is in a starting state or a running state, disabling the prompt function.

The present invention further provides an apparatus for determining a state of a generator in a power supply system as defined in the appended claims.

According to the present invention, a state of a generator is monitored to determine, in a timely manner, whether an excitation system is switched on when the generator is in a standstill state, and a prompt message is sent, so that an operator can perform follow-up processing operations according to the prompt message; this allows a reduction of damage to the generator.

According to the apparatus as described above, optionally, the first monitoring unit is specifically used for:
periodically judging whether the generator meets the following preset condition: the frequency of the generator is smaller than or equal to a first preset threshold;
and, if the judgment result is yes, determining that the generator is in the standstill state.

According to the apparatus as described above, optionally, the preset condition further comprises: an output voltage of the generator is smaller than or equal to a second preset threshold.

The apparatus as described above, optionally, further comprises:
a trigger unit used for triggering a switch-off operation of the excitation system.

According to the apparatus as described above, optionally, the first monitoring unit is further used for:
after monitoring that the generator is in a standstill state, activating the second monitoring unit and the sending unit.

According to the apparatus as described above, optionally, the first monitoring unit is further used for:
if it is monitored that the generator is in a starting state or a running state, blocking the second monitoring unit and the sending unit.

The present invention further provides a power supply system as defined in the appended claims.

The present invention further provides an apparatus for determining a state of a generator in a power supply system as defined in the appended claims.

The present invention further provides a readable storage medium storing a machine-readable instruction that, when executed by a machine, causes the machine to implement a method for determining a state of a generator in a power supply system as described above.

### Brief Description of the Drawings

Preferred embodiments of the present invention will be described in detail below with reference to the drawings to make the above-described and other characteristics and benefits of the present invention clearer to those of ordinary skill in the art. Among the drawings,
Figure 1 is a schematic flowchart for a method for determining a state of a generator in a power supply system according to an embodiment of the present invention;
Figure 2 is a schematic flowchart for a method for determining a state of a generator in a power supply system according to another embodiment of the present invention;
Figure 3 is a schematic structural diagram for an apparatus for determining a state of a generator in a power supply system according to an embodiment of the present invention; and
Figure 4 is a schematic structural diagram for an apparatus for determining a state of a generator in a power supply system according to still another embodiment of the present invention.

### Specific Embodiments

In order to further clarify the objective, technical solution, and benefits of the present invention, the present invention will be described below in greater detail with reference to embodiments.

A generator may be in one of three states: standstill, starting, and running. Transitions between the states may be divided into the following types:
type 1: from a standstill state to a starting state;
type 2: from a starting state to a running state; and
type 3: from a running state to a standstill state.

The inventor discovered that after a generator in a power supply system has remained in a standstill state for a period of time, sometimes the circuit of the generator is damaged to a certain extent; the power supply system is located, for example, in a power plant. Based on this discovery, the inventor, after conducting research, found that when a generator is in a standstill state, if an excitation system used for the generator is in an operating state, then a relatively high current will be generated in the excitation system. Since the excitation system is connected to the circuit of the generator, an excessively high current will affect the generator; if this condition persists, the circuit of the generator will be damaged. The above-described condition occurs when an operator mistakenly switches on the excitation system, that is, if the excitation system is switched on while the generator is in a standstill state. Therefore, the present invention provides a method for determining a state of a generator in a power supply system, so as to monitor whether the corresponding excitation system is switched on when the generator is in a standstill state.

### Embodiment 1

This embodiment provides a method for determining a state of a generator in a power supply system, in which the main execution unit is an apparatus for determining a state of a generator in a power supply system; the apparatus may be located in a generator or in an excitation system, or may be a standalone apparatus, for example, a background capable of monitoring a generator and an excitation system at the same time.

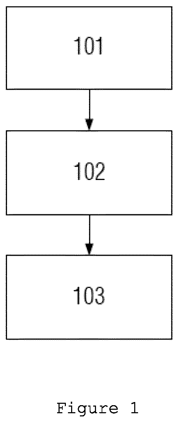

See Figure 1, which is a schematic flowchart for a method for determining a state of a generator in a power supply system according to this embodiment. The method comprises:
Step 101: Monitor whether the generator is in a standstill state.

For example, various parameters related to the running of the generator are monitored to determine whether the generator is in a standstill state. Specifically, these parameters may be acquired periodically and then analyzed. These parameters are, for example, the frequency, voltage, current, rotation speed, etc. of the generator, and may be acquired directly by using various sensors or by processing parameters.

As an illustrative example, the frequency of a generator may be acquired periodically; if the frequency of the generator is smaller than or equal to a first preset threshold, it may be determined that the generator is in a standstill state. The frequency may be obtained, for example, by a sensor; a voltage or a current, for example, may be obtained and then the frequency may be calculated using the voltage or current; if the frequency is smaller than a first preset threshold, then it is determined that the generator is in a standstill state. Certainly, it may be further determined whether the generator is in a standstill state by further determining whether an output voltage of the generator is smaller than or equal to a second preset threshold. This step and the frequency judgment may be performed at the same time, or may be performed sequentially, without being subject to specific restrictions. If the output voltage of the generator is smaller than or equal to the second preset threshold and the frequency of the generator is smaller than or equal to the first preset threshold, then it is determined that the generator is in a standstill state. The second preset threshold mentioned herein may specifically be the remanence voltage, which refers to the voltage measured, by using only the remanence of the iron core without applying excitation, at an end of the generator when the generator is rotating; generally, the remanence voltage of a generator is relatively low.

Step 102: If the monitoring result is yes, monitor whether an excitation system is switched on, the excitation system being used for supplying power to the generator.

An excitation system may be in one of two states: switched on and switched off. When switched on, the excitation system is in an operating state and its circuit is carrying a DC current; when switched off, the excitation system is in a shutdown state and its circuit is carrying no currents. Whether the excitation system is switched on or not may be specifically determined by judging whether a DC voltage of the excitation system is greater than a third preset threshold, which will not be described in detail again herein. How to obtain a DC voltage of an excitation system pertains to the prior art, and thus will not be described in detail again herein.

Step 103: If it is monitored that the excitation system is switched on, send a prompt message indicating that the excitation system is switched on.

The prompt message may be sent in various forms; for example, it is possible to inform an operator by giving a voice prompt, sending a short message, displaying a message on a screen, etc. and, after receiving the prompt message, the operator can perform follow-up operations, such as manually disconnecting the excitation system; certainly, an apparatus for determining a state of a generator in the power supply system can also automatically trigger a switch-off operation of the excitation system, and such automatic control allows the excitation system to be switched off as soon as possible, thereby reducing damage to the generator circuit.

According to the present invention, a state of a generator is monitored to determine, in a timely manner, whether an excitation system is switched on when the generator is in a standstill state, and a prompt message is sent, so that an operator can perform follow-up processing operations according to the prompt message; this allows a reduction of damage to the generator.

### Embodiment 2

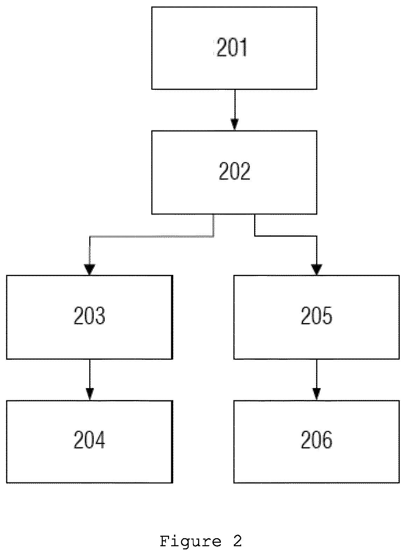

This embodiment further explains the method for determining a state of a generator in a power supply system of the first embodiment. See Figure 2, which is a schematic flowchart for a method for determining a state of a generator in a power supply system according to this embodiment. The method comprises:
Step 201: Monitor whether the generator is in a standstill state, and if the monitoring result is yes, proceed to step 202.

Specifically, it is possible to determine whether the generator is in a standstill state by periodically acquiring relevant parameters of the generator; the period may be determined according to actual needs, for example, once every 1 second. Further, it is possible to judge whether relevant parameters of the generator meet the following preset condition: the frequency of the generator is smaller than or equal to a first preset threshold; if the judgment result is yes, it is determined that the generator is in a standstill state. Certainly, the preset condition may further comprise: a voltage of the generator is smaller than or equal to a second preset threshold and/or a rotation speed of the generator has dropped to a threshold. If the above-described preset condition is met, then it may be determined that the generator is in a standstill state. The monitoring method may be, for example, the specific monitoring method adopted in step 101, which will not be detailed again herein.

Step 202: Activate a prompt function to trigger step 203, and perform step 205.

A prompt function is not activated until it is determined that the generator is in a standstill state, which allows a reduction of the burden on relevant equipment. The prompt function is used for monitoring whether an excitation system is switched on and, after it is monitored that the system is switched on, sending a prompt message.

In other words, activation of the prompt function means that step 203 and step 204 may be triggered in sequence.

Step 203: Monitor whether the excitation system is switched on, and if the monitoring result is yes, proceed to step 204.

Specifically, how to monitor whether an excitation system is switched on is the same as step 102, and thus not be detailed again herein.

Step 204: Send a prompt message.

The prompt message may be sent in various forms, for example, by giving a voice prompt, sending a short message, or displaying a message on an operator's monitoring computer; the prompt message may also be sent to another functional module of an apparatus for determining a state of a generator in the power supply system, for example, a functional module capable of triggering a switch-off operation of an excitation system.

Step 205: Monitor whether the generator is in a starting state or a running state, and if the monitoring result is yes, then proceed to step 206.

Likewise, based on periodically acquired state parameters of the generator, it may be determined that the generator is in a starting state, for example, if the generator meets the following conditions at the same time:
condition 1: a voltage of the generator is greater than or equal to a third preset threshold;
condition 2: the frequency of the generator is greater than or equal to a fourth preset threshold; and
condition 3: a generator circuit-breaker of the generator is turned on.

If the above-described conditions are met, it indicates that the generator has switched from a standstill state to a starting state. A voltage of a generator may be obtained in real time according to data collected by a voltage sensor, and whether the generator circuit-breaker (GCB) of the generator is started may also be determined in real time according to data collected by a corresponding sensor. The GCB completes the function of connecting a generator and a transformer, or is used for connecting a generator and a power grid. Whether the GCB is turned on or not may be determined by monitoring the real-time status of the GCB. Certainly, it is also possible to judge whether a generator is in a starting state by another method, which will not be detailed again herein.

Condition 3 may further comprise judging, at the same time, whether the GCB is turned on and whether a current carried by the generator is greater than a minimum switching current; if these two judgment results are yes at the same time, it indicates that condition 3 is satisfied.

As an illustrative example, if a generator meets the following conditions at the same time, then it indicates that the generator is in a running state:
condition 4: a voltage of the generator is greater than or equal to a third preset threshold;
condition 5: the frequency of the generator is greater than or equal to a fourth preset threshold; and
condition 6: the GCB of the generator is turned on.

If condition 4, condition 5, and condition 6 are met, then it indicates that the generator is in a running state. Specifically, whether a generator is in a running state may also be judged by another method, which will not be detailed again herein.

Condition 6 may further comprise judging, at the same time, whether the GCB is turned on, whether a current carried by the generator is greater than a minimum switching current, and whether the power of the generator is greater than a fifth preset threshold; if these three judgment results are yes at the same time, then it indicates that condition six is met. Thus, judging a plurality of conditions at the same time can ensure that a judgment result is accurate.

Step 206: Disable the prompt function.

If it is determined that the generator has switched from a standstill state to a starting state or a running state, then the prompt function is disabled to allow a reduction in the workload of the corresponding equipment.

After the prompt function is disabled, step 203 and step 204 will no longer be performed in sequence, but step 203 or step 204 may still be performed separately or neither step will be performed, depending on actual needs.

With a method for determining a state of a generator in a power supply system according to this embodiment, after it is monitored that the generator is in a standstill state, the function for monitoring whether an excitation system is switched on is enabled and, when it is monitored that the excitation system is switched on, a prompt message is sent in a timely manner; and the function for monitoring whether an excitation system is switched on is disabled when the generator is out of a standstill state. Thus, damage to the circuit of the generator may be minimized, while the workload of the corresponding equipment is reduced.

### Embodiment 3

This embodiment provides an apparatus for determining a state of a generator in a power supply system, which is used to implement the method for determining a state of a generator in a power supply system according to the above-described embodiments. The apparatus may be located in a generator or in an excitation system, or it may be a standalone apparatus, for example, a background capable of monitoring a generator and an excitation system at the same time.

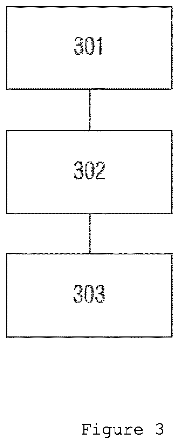

See Figure 3, which is a schematic structural diagram for an apparatus for determining a state of a generator in a power supply system according to this embodiment. The apparatus comprises a first monitoring unit 301, a second monitoring unit 302, and a sending unit 303.

The first monitoring unit 301 is used for monitoring whether a generator is in a standstill state, and if the monitoring result is yes, a second monitoring unit 302 is triggered; the second monitoring unit 302 is used for monitoring whether an excitation system for supplying power to a generator is switched on, and if it is monitored that the excitation system is switched on, a sending unit 303 is triggered; and the sending unit 303 is used for sending a prompt message, the prompt message indicating that the excitation system is switched on.

Optionally, the first monitoring unit 301 is specifically used for:
periodically judging whether the generator meets the following preset condition: the frequency of the generator is smaller than or equal to a first preset threshold; if the judgment result is yes, it is determined that the generator is in a standstill state.

Optionally, the preset condition further comprises: an output voltage of the generator is smaller than or equal to a second preset threshold.

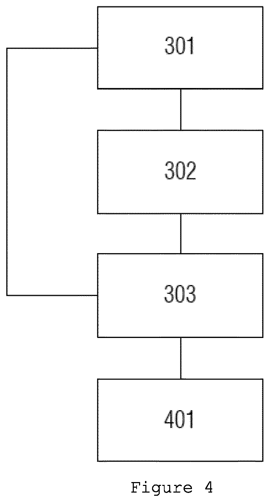

Optionally, as shown in Figure 4, the apparatus further comprises a trigger unit 401, the trigger unit 401 being used for triggering a switch-off operation of an excitation system. As shown in Figure 4, the trigger unit 401 may be triggered by the sending unit 303, and certainly may also be triggered by the second monitoring unit 302, depending on actual needs.

Optionally, as shown in Figure 4, the first monitoring unit 301 of this embodiment is further used for, after monitoring that the generator is in a standstill state, starting the second monitoring unit 302 and the sending unit 303. The starting mentioned herein can mean causing both the second monitoring unit 302 and the sending unit 303 to reach a state of being able to run; thus, the second monitoring unit 302 can, upon being triggered by the first monitoring unit 301, monitor whether an excitation system is switched on, and can trigger the sending unit 303.

Optionally, as shown in Figure 4, the first monitoring unit 301 of this embodiment is further used for, if it is monitored that the generator is in a starting state or a running state, blocking the second monitoring unit 302 and the sending unit 303. This allows saving of power while reducing the operating workload.

Each unit of this embodiment operates in the same manner as those of the previous embodiment, and thus no similar description will be provided again herein.

According to the present invention, a state of a generator is monitored to determine, in a timely manner, whether an excitation system is switched on when the generator is in a standstill state, and a prompt message is sent, so that an operator can perform follow-up processing operations according to the prompt message; this allows a reduction of damage to the generator.

The present invention further provides a power supply system comprising a generator, an excitation system, and an apparatus for determining a state of a generator in a power supply system according to any one of the above-described embodiments.

The present invention further provides an apparatus for determining a state of a generator in a power supply system, which comprises at least one memory and at least one processor, wherein the memory is used for storing an instruction and the processor is used for implementing, according to an instruction stored in the memory, a method for determining a state of a generator in a power supply system as described in any of the preceding embodiments.

An embodiment of the present invention further provides a readable storage medium. The readable storage medium stores a machine-readable instruction that, when executed by a machine, causes the machine to implement a method for determining a state of a generator in a power supply system as described in any of the preceding embodiments.

The readable medium stores a machine-readable instruction that, when executed by a processor, causes the processor to implement any of the methods as described above. Specifically, a system or apparatus can be provided that is equipped with a readable medium storing a software program code for implementing the functions of any of the embodiments described above, and the computer or processor of the system or apparatus is caused to read out and execute a machine-readable instruction stored in the readable storage medium.

In this case, the program code read from the machine-readable medium itself can implement the functions of any of the above embodiments, and therefore the machine-readable code and the readable medium storing the machine-readable code form a portion of the present invention.

Examples of readable storage media include floppy disk, hard disk, magneto-optical disk, optical disk (for example, CD-ROM, CD-R, CD-RW, DVD-ROM, DVD-RAM, DVD-RW, and DVD+RW), magnetic tape, non-volatile memory card, and ROM. Alternatively, program code may be downloaded from a server computer or cloud via a communication network.

Those of ordinary skill in the art should understand that various transformations and modifications may be made to the embodiments disclosed above without departing from the essence of the present invention. Therefore, the scope of protection of the present invention should be defined by the appended claims.

It should be noted that not all the steps or units in the above-described flows and system structural diagrams are required, and certain steps or units may be omitted as needed. The sequence of performing steps is not fixed and may be adjusted as needed. The apparatus structures described in the above embodiments may be physical structures or logical structures; in other words, certain units may be implemented as the same physical entity, or certain units may be implemented as a plurality of physical entities separately, or certain units may be jointly implemented by certain components in a plurality of standalone devices.

In each of the above embodiments, a hardware unit may be implemented mechanically or electrically. For example, a hardware unit or processor may comprise a permanently dedicated circuit or logic, for example, a special processor, an FPGA, or an ASIC, for completing corresponding operations. A hardware unit or processor may further comprise programmable logic or circuitry (for example, a general-purpose processor or any other programmable processor), which may be temporarily configured by software to perform corresponding operations. Specific implementations (mechanical, or dedicated permanent circuits, or temporarily configured circuits) may be determined on the basis of cost and time considerations.

While the present invention has been described and illustrated in detail above with reference to the drawings and preferred embodiments, the present invention is not limited to these disclosed embodiments, and more embodiments of the present invention may be obtained by combining the code auditing means in the different embodiments described above, as can be appreciated by those of ordinary skill in the art based on the above-mentioned embodiments; these embodiments also fall within the scope of protection of the present invention.

## Claims

1. A method for determining a state of a generator in a power supply system, wherein the generator is used for supplying power to a transmission grid, **characterized in that** the method comprises:
monitoring (101) whether the generator is in a standstill state;
if the monitoring result is yes, monitoring (102) whether an excitation system is switched on, the excitation system being used for supplying power to the generator; and
if it is monitored that the excitation system is switched on, sending (103) a prompt message, the prompt message being used for indicating that the excitation system is switched on.

2. The method as claimed in claim 1, **characterized in that** said monitoring whether the generator is in a standstill state comprises:
periodically judging whether the generator meets the following preset condition:
the frequency of the generator is smaller than or equal to a first preset threshold;
and, if the judgment result is yes, determining that the generator is in the standstill state.

3. The method as claimed in claim 2, **characterized in that** the preset condition further comprises:
an output voltage of the generator is smaller than or equal to a second preset threshold.

4. The method as claimed in any one of claims 1 to 3, **characterized by**, after monitoring that the excitation system is switched on, further comprising:
triggering a switch-off operation of the excitation system.

5. The method as claimed in any one of claims 1 to 4, further comprising:
after monitoring that the generator is in a standstill state, activating (202) a prompt function, the prompt function being used for monitoring (203) whether the excitation system is switched on and, after monitoring that it is switched on, sending (204) the prompt message.

6. The method as claimed in claim 5, **characterized by**, after activating (202) the prompt function, further comprising:
if it is monitored (205) that the generator is in a starting state or a running state, disabling (206) the prompt function.

7. An apparatus for determining a state of a generator in a power supply system, the generator being used for supplying power to a transmission grid, **characterized in that** the apparatus comprises:
a first monitoring unit (301) configured to monitor (101) whether the generator is in a standstill state, and if the monitoring result is yes, to trigger a second monitoring unit (302);
the second monitoring unit (302), configured to monitor (102) whether an excitation system is switched on, the excitation system being used for supplying power to the generator, and if it is monitored that the excitation system is switched on, to trigger a sending unit (303); and
the sending unit (303), configured to send (103) a prompt message, the prompt message being used for indicating that the excitation system is switched on.

8. The apparatus as claimed in claim 7, **characterized in that** the first monitoring unit (301) is specifically configured to:
periodically judge whether the generator meets the following preset condition: the frequency of the generator is smaller than or equal to a first preset threshold;
and, if the judgment result is yes, determine that the generator is in the standstill state.

9. The apparatus as claimed in claim 8, **characterized in that** the preset condition further comprises:
an output voltage of the generator is smaller than or equal to a second preset threshold.

10. The apparatus as claimed in claim 7, **characterized by** further comprising:
a trigger unit (401) configured to trigger a switch-off operation of the excitation system.

11. The apparatus as claimed in any one of claims 7 to 10, **characterized in that** the first monitoring unit (301) is further configured to:
after monitoring that the generator is in a standstill state, activate the second monitoring unit (302) and the sending unit (303).

12. The apparatus as claimed in claim 11, **characterized in that** the first monitoring unit (301) is further configured to:
if it is monitored that the generator is in a starting state or a running state, block the second monitoring unit (302) and the sending unit (303).

13. A power supply system, comprising:
a generator;
an excitation system for supplying power to the generator; and
an apparatus for determining a state of a generator in a power supply system as claimed in any one of claims 7 to 12.

14. An apparatus for determining a state of a generator in a power supply system, the generator being used for supplying power to a transmission grid, **characterized in that** the apparatus comprises:
at least one memory configured to store an instruction; and
at least one processor configured to implement, according to an instruction stored in the memory, the method for determining a state of a generator in a power supply system as claimed in any one of claims 1 to 6.

15. A readable storage medium, **characterized by** storing a machine-readable instruction that, when executed by a machine, causes the machine to implement the method for determining a state of a generator in a power supply system as claimed in any one of claims 1 to 6.

## Patentansprüche

1. Verfahren zum Bestimmen eines Zustands eines Generators in einem Leistungsversorgungssystem, wobei der Generator zum Zuführen von Leistung zu einem Übertragungsnetz verwendet wird, **dadurch gekennzeichnet, dass** das Verfahren Folgendes umfasst:
Überwachen (101), ob sich der Generator in einem Stillstandszustand befindet;
falls das Überwachungsergebnis ja ist, Überwachen (102), ob ein Erregungssystem eingeschaltet ist, wobei das Erregungssystem zum Zuführen von Leistung zu dem Generator verwendet wird; und
falls das Überwachen ergibt, dass das Erregungssystem eingeschaltet ist, Senden (103) einer Aufforderungsnachricht, wobei die Aufforderungsnachricht zum Anzeigen, dass das Erregungssystem eingeschaltet ist, verwendet wird.

2. Verfahren nach Anspruch 1, **dadurch gekennzeichnet, dass** das Überwachen, ob sich der Generator in einem Stillstandszustand befindet, Folgendes umfasst:
regelmäßiges Beurteilen, ob der Generator die folgende voreingestellte Bedingung erfüllt:
die Frequenz des Generators ist kleiner als oder gleich einem ersten voreingestellten Schwellenwert;
und, falls das Beurteilungsergebnis ja ist, Bestimmen, dass sich der Generator in dem Stillstandszustand befindet.

3. Verfahren nach Anspruch 2, **dadurch gekennzeichnet, dass** die voreingestellte Bedingung ferner Folgendes umfasst:
eine Ausgangsspannung des Generators ist kleiner als oder gleich einem zweiten voreingestellten Schwellenwert.

4. Verfahren nach einem der Ansprüche 1 bis 3, **dadurch gekennzeichnet, dass** es nach dem Überwachen, dass das Erregungssystem eingeschaltet ist, ferner Folgendes umfasst:
Auslösen eines Abschaltvorgangs des Erregungssystems.

5. Verfahren nach einem der Ansprüche 1 bis 4, das ferner Folgendes umfasst:
nach dem Überwachen, dass sich der Generator in einem Stillstandszustand befindet, Aktivieren (202) einer Aufforderungsfunktion, wobei die Aufforderungsfunktion zum Überwachen (203), ob das Erregungssystem eingeschaltet ist, verwendet wird, und nach dem Überwachen, dass es eingeschaltet ist, Senden (204) der Aufforderungsnachricht.

6. Verfahren nach Anspruch 5, **dadurch gekennzeichnet, dass** es nach dem Aktivieren (202) der Aufforderungsfunktion ferner Folgendes umfasst:
falls das Überwachen (205) ergibt, dass sich der Generator in einem Startzustand oder einem laufenden Zustand befindet, Deaktivieren (206) der Aufforderungsfunktion.

7. Einrichtung zum Bestimmen eines Zustands eines Generators in einem Leistungsversorgungssystem, wobei der Generator zum Zuführen von Leistung zu einem Übertragungsnetz verwendet wird, **dadurch gekennzeichnet, dass** die Einrichtung Folgendes umfasst:
eine erste Überwachungseinheit (301), die dazu ausgelegt ist, zu überwachen (101), ob sich der Generator in einem Stillstandszustand befindet, und, falls das Überwachungsergebnis ja ist, eine zweite Überwachungseinheit (302) auszulösen;
die zweite Überwachungseinheit (302), die dazu ausgelegt ist, zu überwachen (102), ob ein Erregungssystem eingeschaltet ist, wobei das Erregungssystem zum Zuführen von Leistung zu dem Generator verwendet wird, und, falls das Überwachen ergibt, dass das Erregungssystem eingeschaltet ist, eine Sendeeinheit (303) auszulösen; und
die Sendeeinheit (303), die dazu ausgelegt ist, eine Aufforderungsnachricht zu senden (103), wobei die Aufforderungsnachricht zum Anzeigen, dass das Erregungssystem eingeschaltet ist, verwendet wird.

8. Einrichtung nach Anspruch 7, **dadurch gekennzeichnet, dass** die erste Überwachungseinheit (301) insbesondere zu Folgendem ausgelegt ist:
regelmäßiges Beurteilen, ob der Generator die folgende voreingestellte Bedingung erfüllt: die Frequenz des Generators ist kleiner als oder gleich einem ersten voreingestellten Schwellenwert;
und, falls das Beurteilungsergebnis ja ist, Bestimmen, dass sich der Generator in dem Stillstandszustand befindet.

9. Einrichtung nach Anspruch 8, **dadurch gekennzeichnet, dass** die voreingestellte Bedingung ferner Folgendes umfasst:
eine Ausgangsspannung des Generators ist kleiner als oder gleich einem zweiten voreingestellten Schwellenwert.

10. Einrichtung nach Anspruch 7, **dadurch gekennzeichnet, dass** sie ferner Folgendes umfasst:
eine Auslöseeinheit (401), die dazu ausgelegt ist, einen Abschaltvorgang des Erregungssystems auszulösen.

11. Einrichtung nach einem der Ansprüche 7 bis 10, **dadurch gekennzeichnet, dass** die erste Überwachungseinheit (301) ferner zu Folgendem ausgelegt ist:
nach dem Überwachen, dass sich der Generator in einem Stillstandszustand befindet, Aktivieren der zweiten Überwachungseinheit (302) und der Sendeeinheit (303).

12. Einrichtung nach Anspruch 11, **dadurch gekennzeichnet, dass** die erste Überwachungseinheit (301) ferner zu Folgendem ausgelegt ist:
falls das Überwachen ergibt, dass sich der Generator in einem Startzustand oder einem laufenden Zustand befindet, Sperren der zweiten Überwachungseinheit (302) und der Sendeeinheit (303).

13. Leistungsversorgungssystem, das Folgendes umfasst:
einen Generator;
ein Erregungssystem zum Zuführen von Leistung zu dem Generator; und
eine Einrichtung zum Bestimmen eines Zustands eines Generators in einem Leistungsversorgungssystem nach einem der Ansprüche 7 bis 12.

14. Einrichtung zum Bestimmen eines Zustands eines Generators in einem Leistungsversorgungssystem, wobei der Generator zum Zuführen von Leistung zu einem Übertragungsnetz verwendet wird, **dadurch gekennzeichnet, dass** die Einrichtung Folgendes umfasst:
mindestens einen Speicher, der dazu ausgelegt ist, eine Anweisung zu speichern; und
mindestens einen Prozessor, der dazu ausgelegt ist, gemäß einer im Speicher gespeicherten Anweisung das Verfahren zum Bestimmen eines Zustands eines Generators in einem Leistungsversorgungssystem nach einem der Ansprüche 1 bis 6 zu implementieren.

15. Lesbares Speichermedium, **dadurch gekennzeichnet, dass** es eine maschinenlesbare Anweisung speichert, die, wenn sie durch eine Maschine ausgeführt wird, die Maschine veranlasst, das Verfahren zum Bestimmen eines Zustands eines Generators in einem Leistungsversorgungssystem nach einem der Ansprüche 1 bis 6 zu implementieren.

## Revendications

1. Procédé de détermination de l'état d'un générateur dans un système d'alimentation électrique, le générateur étant utilisé pour fournir de l'énergie à un réseau de transmission, **caractérisé en ce que** le procédé comprend les étapes consistant à :
vérifier (101) si le générateur est dans un état d'arrêt ;
si le résultat de la vérification est oui, vérifier (102) si un système d'excitation est en marche, le système d'excitation étant utilisé pour fournir de l'énergie au générateur ; et
s'il est vérifié que le système d'excitation est en marche, envoyer (103) un message d'invite, le message d'invite étant utilisé pour indiquer que le système d'excitation est en marche.

2. Procédé selon la revendication 1, **caractérisé en ce que** ladite vérification du fait que le générateur est dans un état d'arrêt comprend les étapes consistant à :
évaluer périodiquement si le générateur remplit les conditions préétablies suivantes :
la fréquence du générateur est inférieure ou égale à un premier seuil prédéfini ;
et, si le résultat de l'évaluation est oui, déterminer que le générateur est dans l'état d'arrêt.

3. Procédé selon la revendication 2, **caractérisé en ce que** la condition prédéfinie comprend en outre :
une tension de sortie du générateur est inférieure ou égale à un second seuil prédéfini.

4. Procédé selon l'une quelconque des revendications 1 à 3, **caractérisé en ce que**, après avoir vérifié que le système d'excitation est en marche, il comprend en outre l'étape consistant à :
déclencher une opération d'arrêt du système d'excitation.

5. Procédé selon l'une quelconque des revendications 1 à 4, comprenant en outre les étapes consistant à :
après avoir vérifié que le générateur est dans un état d'arrêt, activer (202) une fonction d'invite, la fonction d'invite étant utilisée pour vérifier (203) si le système d'excitation est en marche et, après avoir vérifié qu'il est en marche, envoyer (204) le message d'invite.

6. Procédé selon la revendication 5, **caractérisé en ce que**, après avoir activé (202) la fonction d'invite, il comprend en outre l'étape consistant à :
s'il est vérifié (205) que le générateur est dans un état de démarrage ou dans un état de fonctionnement, désactiver (206) la fonction d'invite.

7. Appareil de détermination de l'état d'un générateur dans un système d'alimentation électrique, le générateur étant utilisé pour fournir de l'énergie à un réseau de transmission, **caractérisé en ce que** l'appareil comprend :
une première unité de vérification (301) conçue pour vérifier (101) si le générateur est dans un état d'arrêt et, si le résultat de la vérification est positif, pour déclencher une seconde unité de vérification (302) ;
la seconde unité de vérification (302), conçue pour vérifier (102) si un système d'excitation est en marche, le système d'excitation étant utilisé pour fournir de l'énergie au générateur, et s'il est vérifié que le système d'excitation est en marche, pour déclencher une unité d'envoi (303) ; et
l'unité d'envoi (303), conçue pour envoyer (103) un message d'invite, le message d'invite étant utilisé pour indiquer que le système d'excitation est en marche.

8. Appareil selon la revendication 7, **caractérisé en ce que** la première unité de vérification (301) est conçue spécifiquement pour :
évaluer périodiquement si le générateur remplit la condition prédéfinie suivante : la fréquence du générateur est inférieure ou égale à un premier seuil prédéfini ;
et, si le résultat de l'évaluation est oui, déterminer que le générateur est dans l'état d'arrêt.

9. Appareil selon la revendication 8, **caractérisé en ce que** la condition prédéfinie comprend en outre :
une tension de sortie du générateur est inférieure ou égale à un second seuil prédéfini.

10. Appareil selon la revendication 7, **caractérisé en ce qu'**il comprend en outre :
une unité de déclenchement (401) conçue pour déclencher une opération de mise à l'arrêt du système d'excitation.

11. Appareil selon l'une quelconque des revendications 7 à 10, **caractérisé en ce que** la première unité de vérification (301) est en outre conçue pour :
après avoir vérifié que le générateur est dans un état d'arrêt, activer la seconde unité de vérification (302) et l'unité d'envoi (303).

12. Appareil selon la revendication 11, **caractérisé en ce que** la première unité de vérification (301) est en outre conçue pour :
s'il est vérifié que le générateur est dans un état de démarrage ou dans un état de fonctionnement, bloquer la seconde unité de vérification (302) et l'unité d'envoi (303).

13. Système d'alimentation électrique comprenant :
un générateur ;
un système d'excitation destiné à alimenter le générateur ; et
un appareil destiné à déterminer l'état d'un générateur dans un système d'alimentation électrique selon l'une quelconque des revendications 7 à 12.

14. Appareil de détermination de l'état d'un générateur dans un système d'alimentation électrique, le générateur étant utilisé pour fournir de l'énergie à un réseau de transmission, **caractérisé en ce que** l'appareil comprend :
au moins une mémoire conçue pour stocker une instruction ; et
au moins un processeur conçu pour mettre en œuvre, selon une instruction stockée dans la mémoire, le procédé de détermination de l'état d'un générateur dans un système d'alimentation selon l'une quelconque des revendications 1 à 6.

15. Support de stockage lisible, **caractérisé par** le stockage d'une instruction lisible par une machine qui, lorsqu'elle est exécutée par une machine, amène la machine à mettre en œuvre le procédé pour déterminer l'état d'un générateur dans un système d'alimentation électrique selon l'une quelconque des revendications 1 à 6.
